# FASCICULE DE BREVET EUROPEEN

(11) **EP 2 476 301 B1**
(45) Date de publication et mention de la délivrance du brevet: **12.03.2014**
(21) Numéro de dépôt: 10747886.9
(22) Date de dépôt: 03.09.2010
(51) Int. Cl.: H05K 7/20, H01L 23/427

(54) **SYSTEME DE CONTROLE THERMIQUE D'UN EQUIPEMENT**
SYSTEM ZUR THERMISCHEN STEUERUNG EINES GERÄTS
SYSTEM FOR THERMALLY CONTROLLING AN APPARATUS

(30) Priorité: 08.09.2009 FR 0904273
(43) Date de publication de la demande: 18.07.2012
(73) Titulaire: Thales, 92200 Neuilly Sur Seine (FR)
(72) Inventeur: RAYNAUD, Martin, F-92700 Colombes (FR)
(74) Mandataire: Dudouit, Isabelle
(86) Numéro de dépôt international: PCT/EP2010/062938
(87) Numéro de publication internationale: WO 2011/029778

(56) Documents cités:
- JP-A- 59 094 445
- US-A1- 2005 286 227
- US-A1- 2007 193 300

## Description

L'objet de l'invention concerne un système permettant de contrôler thermiquement un boitier, un ou des éléments, un ou des composants ou tout dispositif dégageant de la chaleur avec lequel il est mis en contact. Le dégagement de chaleur peut se faire de manière continue ou par intermittence.

L'invention s'applique pour refroidir lesdits éléments précités lors de leur fonctionnement. Elle s'applique à tout type d'élément, en particulier à des éléments dont la taille est faible, tels que des composants électroniques ou des boîtiers contenant des composants.

Tous les dispositifs électriques ou électrochimiques en fonctionnement sont le siège de pertes d'énergie qui se manifestent sous forme de chaleur. La miniaturisation, notamment des équipements électroniques, conjointement à l'augmentation de la puissance dissipée, nécessitent une conception thermique de plus en plus élaborée de ces dispositifs afin de maintenir la température des composants dans leur domaine de tolérances de fonctionnement. En dehors de certaines limites de température, leurs performances sont médiocres voire totalement défaillantes. En outre, certains équipements doivent fonctionner sous des climats chauds et ensoleillés et ce, sans avoir recours à des sources de refroidissement active externe. L'évacuation de la chaleur est donc un problème crucial, chaque élément ou dispositif devant être maintenu à sa température nominale de fonctionnement. Ainsi, face à l'augmentation de la puissance thermique dissipée par unité de surface, il existe actuellement un besoin pour des systèmes compacts et robustes permettant d'absorber les pics de charge thermique afin que les équipements ne dépassent pas les températures maximales admissibles. Ces systèmes sont dénommés dissipateur thermique.

Il existe actuellement de nombreuses solutions basées essentiellement sur des systèmes de refroidissement actifs : mini-pompe à chaleur fonctionnant selon un cycle frigorifique, chambre avec circulation d'eau avec ou sans changement de phase, ventilateur, module thermoélectrique, ... Les micro-jets d'air ou de gouttelettes d'eau sont plutôt dédiés au refroidissement des composants et non des systèmes.

Malgré les performances qu'ils offrent, ces dispositifs présentent toutefois les inconvénients suivants. La plupart de ces dispositifs nécessitent une source d'énergie externe, ils sont relativement volumineux, voire bruyants et leur miniaturisation s'avère délicate et souvent accompagnée d'une dégradation de leur rendement.

Le fonctionnement passif basé sur des matériaux à changement de phase (en abrégé MCP) solide/liquide (paraffines, etc.) connaît actuellement un fort développement, mais principalement dans les domaines du bâtiment et des procédés industriels. Leur efficacité est cependant limitée du fait de la valeur modérée de la chaleur latente (environ 180J/g) et surtout, par le fait que la température de fusion n'est pas contrôlable en régime dynamique ; en effet elle dépend du matériau MCP utilisé. Les MCP amortissent les variations de température mais ils sont surtout bien adaptés aux très grands et grands systèmes pour lesquels les contraintes de volumes ou de poids sont limitées, voire inexistantes.

Le document US 2005/0286227 décrit un système pour refroidir des composants électroniques dégageant de la chaleur comportant une enceinte comprenant une membrane étanche à un liquide et poreuse à la vapeur dudit liquide, ladite membrane séparant l'enceinte en une première cavité destinée à contenir un fluide composé d'un liquide et de sa vapeur, une deuxième cavité destinée contenir de la vapeur résultant de la vaporisation du liquide.

L'objet de la présente invention repose sur une combinaison de solutions techniques, assemblées et contrôlées de façon à obtenir un système de contrôle thermique ou dissipateur thermique autonome, passif, compact dans certains cas, sans impact environnemental et de faible volume relativement à la puissance dissipée.

L'objet de la présente invention concerne un système pour refroidir des boitiers ou équipements susceptibles de dégager de l'énergie caractérisé en ce qu'il comporte au moins les éléments suivants :
Une enceinte comprenant une membrane étanche à un liquide et poreuse à la vapeur dudit liquide, ladite membrane séparant l'enceinte en une première cavité destinée à contenir un fluide composé d'un liquide et de sa vapeur, une deuxième cavité destinée contenir de la vapeur résultant de la vaporisation du liquide,
Un capteur de température adapté à mesurer la température du fluide liquide-vapeur contenue dans la cavité ou la température de paroi de la cavité,
Un dispositif qui va permettre de rejeter dans l'environnement la vapeur de la cavité créant une dépression dans cette cavité et cassant l'équilibre naturel liquide/vapeur de la cavité contenant le liquide, provoquant ainsi une vaporisation d'une partie du liquide,
Un moyen de contrôle du débit de la vapeur rejetée à l'extérieur de la cavité, ledit moyen de contrôle est régulé sur le signal délivré par le capteur de température.

Le liquide de la cavité est, par exemple, de l'eau, et la vapeur, de la vapeur d'eau.

La cavité destinée à contenir le fluide composé de liquide et de vapeur comprend, par exemple, un matériau hygroscopique ou un matériau à forte capillarité.

Le dispositif de rejet de la vapeur à l'extérieur de la cavité peut être une pompe, ou une micro-pompe gaz/vapeur.

La cavité comprenant le fluide liquide-vapeur a, par exemple, une surface S₅, S₂₀ disposée au contact d'une surface S₁ d'un dispositif à refroidir, ladite surface S₅, S₂₀ en contact avec l'équipement étant totalement ou partiellement recouverte d'un matériau poreux hydrophile.

La membrane est disposée, par exemple, dans une position verticale, et en ce que la cavité contenant le fluide est en contact avec le dispositif à refroidir.

La membrane peut aussi être disposée dans une position horizontale et en ce que les deux cavités précitées sont en contact avec une paroi d'un élément à refroidir.

La cavité comprenant le liquide est pourvue d'un orifice permettant l'ajout de liquide et d'un capteur Cn de niveau de liquide.

La cavité contenant le fluide est, par exemple, pourvue de cellulose, soit une mousse capillaire bonne conductrice de la chaleur, soit peut être nervurée pourvue d'ailettes, garantissant ainsi le bon fonctionnement thermique du dispositif quelque soit son inclinaison.

Le système est par exemple utilisé pour refroidir un boitier contenant des composants électroniques ou des composants électrochimiques.

D'autres caractéristiques et avantages du dispositif selon l'invention apparaîtront mieux à la lecture de la description qui suit d'un exemple de réalisation donné à titre illustratif et nullement limitatif annexé des figures qui représentent :
- La figure 1 représente le diagramme d'équilibre eau liquide-vapeur,
- La figure 2, un schéma de principe de refroidissement par évaporation d'un dispositif, et
- La figure 3, une variante de réalisation du dispositif de la figure 2.

Afin de mieux faire comprendre le principe du dispositif selon l'invention, dont un des objectifs est de refroidir des composants, des équipements ou tout autre dispositif susceptible de dégager de la chaleur, la description qui suit est donnée à titre illustratif et nullement limitatif pour le refroidissement d'un équipement susceptible de dégager de la puissance et donc de la chaleur de façon continue ou par intermittence. Dans l'exemple donné à titre nullement limitatif, le liquide utilisé est de l'eau. Toutefois, sans sortir du cadre de l'invention, tout fluide ou mélange de fluides ayant une grande chaleur latente de vaporisation et une courbe de pression de saturation en fonction de la température adaptée au conditions de fonctionnement du système à refroidir pourrait être utilisé. Typiquement, tous les fluides frigorigènes non nocif et à faible impact environnemental sont utilisables.

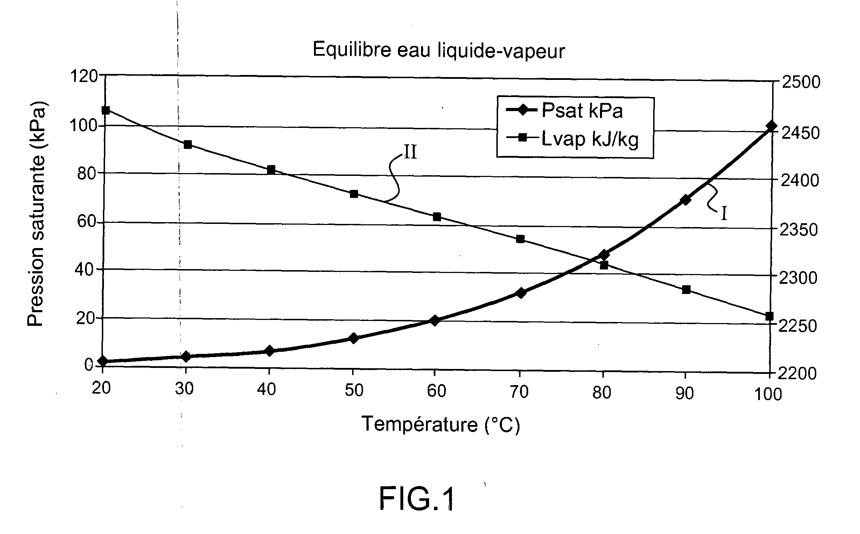

La figure 1 rappelle dans un diagramme température-pression le diagramme d'équilibre eau-vapeur, avec la courbe I de pression de saturation et la courbe II de chaleur latente de vaporisation de l'eau.

Dans une enceinte close, tant que la pression partielle de vapeur P est inférieure à la pression de saturation (qui est fonction de la température T), l'eau se vaporise en puisant de l'énergie à l'environnement, c'est-à-dire dans le cas du présent exemple, soit dans l'eau liquide, soit au niveau de l'équipement à refroidir, jusqu'à ce que la pression partielle de la vapeur soit égale à la pression de saturation.

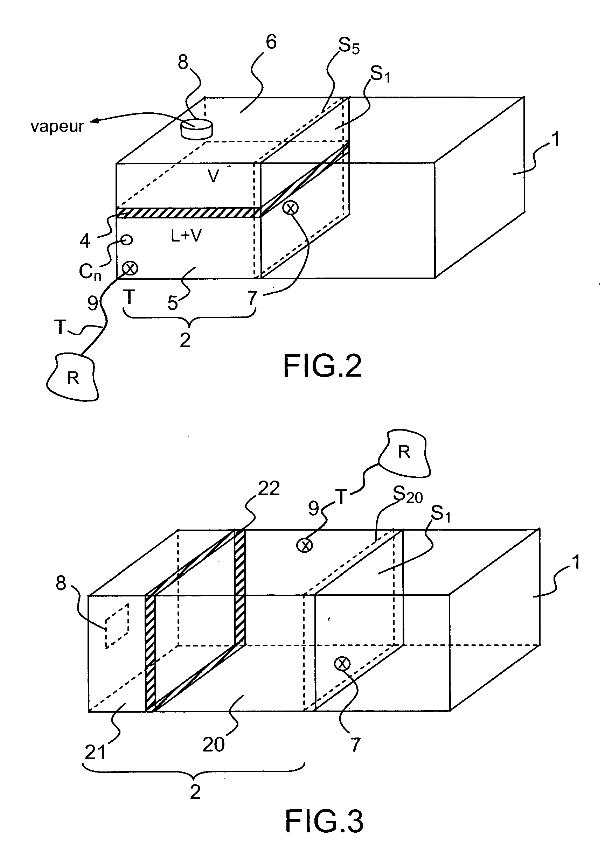

Sur la figure 2 est représenté un premier exemple de mise en oeuvre de l'invention comprenant par exemple un dispositif 1 à refroidir qui dissipe de l'énergie (par intermittence ou de manière continue) et qui est disposé en contact avec un système de contrôle thermique ou dissipateur thermique 2 selon l'invention.

Le système de contrôle thermique selon l'invention est composé d'une enceinte ou cavité 3 comprenant une membrane 4 poreuse à la vapeur d'eau et étanche à l'eau liquide, dans l'exemple donné où le fluide utilisé est de l'eau, ladite membrane séparant l'enceinte en deux parties 5, 6 ou cavités. Une première cavité 5 contient du fluide composé d'eau et de vapeur, une deuxième cavité 6 va contenir de la vapeur d'eau uniquement. L'eau liquide de la cavité 5 se vaporise selon la courbe 1 de la figure 1, la température de la cavité 5 étant influencée par la dissipation de chaleur produite par l'équipement à refroidir. Un capteur de température 7 adapté à mesurer soit la température du fluide liquide-vapeur contenue dans la cavité ou réserve 5, soit la température de la paroi de l'enceinte 3 en contact avec le dispositif à refroidir. Le capteur de température 7 est relié à une pompe 8 qui va permettre de rejeter dans l'environnement la vapeur d'eau de la cavité 6 créant une dépression et du fait de la perméabilité de la membrane 4 à la vapeur d'eau, cassant l'équilibre naturel liquide/vapeur de la cavité 5, provoquant ainsi une vaporisation d'une partie de l'eau liquide. La cavité 5 est pourvue d'un orifice 9 permettant l'introduction de liquide soir directement, soit par l'intermédiaire d'un tuyau T relié à un réservoir R de liquide. La cavité 6 comporte un moyen d'évacuation de la vapeur vers l'extérieur qui est dans l'exemple donné sur la figure 2 la pompe 8. Lorsque le capteur de température 7 détecte ou mesure une valeur de température supérieure à une valeur seuil Vs ou valeur de tolérance à laquelle le dispositif ne va plus fonctionner correctement, alors un signal est transmis vers la pompe 8 afin qu'elle se mette en marche pour évacuer de la vapeur d'eau qui a été généré dans la cavité 6.

La membrane 4 poreuse à la vapeur d'eau et étanche à l'eau liquide est disposée horizontalement dans cet exemple de mise en oeuvre. La perméabilité à la vapeur d'eau et son imperméabilité à l'eau liquide doivent être aussi grande que possible. Typiquement, les membranes Versapor R et Versapor TR commercialisés par la société Pall Corporation, ou les membranes adhésives Gore protective vents (séries VE4 à VE8) commercialisées par la Société Gore répondent à ces spécifications. Cette membrane empêche l'aspiration d'eau liquide par la pompe permettant au dispositif de fonctionner horizontalement, verticalement ou dans n'importe quelle autre position. Cette membrane peut être remplacée par tout autre dispositif séparateur d'état liquide-gaz.

Le contrôle de la pompe 8 permet de réguler le débit de rejet de vapeur d'eau dans l'environnement, donc indirectement le débit de vaporisation de l'eau et de fait, la puissance absorbée à l'équipement à refroidir. L'évacuation de la vapeur d'eau de la cavité 6 vers l'environnement, provoque la vaporisation de l'eau liquide de la cavité 5, vaporisation qui influence la température de la cavité 5. En fonction du bilan d'énergie de la cavité 5 : énergie en provenance du dispositif à refroidir qui traverse la paroi de l'enceinte 3 en contact avec le dispositif à refroidir - énergie perdue par la vaporisation de l'eau, la température de la cavité 5 peut rester supérieure ou redescendre en dessous de la valeur seuil Vs de fonctionnement de la pompe 8. Le système de marche/arrêt de la pompe 8 est donc contrôlé par le capteur de température 7. Le contrôle du fonctionnement de la pompe 8 par le capteur 7 permet de déclencher la vaporisation de l'eau liquide dans la cavité 5 sans que la température de l'eau n'atteigne 100°C (température d'ébullition de l'eau sous la pression atmosphérique) permettant ainsi un refroidissement efficace et donc un contrôle de la température de l'équipement. L'évaporation de l'eau dans la cavité 5 est quasi instantanée. Ainsi, la constante de temps du système selon l'invention peut être très faible. Cette constante de temps dépend de la courbe de fonctionnement (débit-pression) de la pompe 8, de la perméabilité de la membrane et de l'échange thermique au travers de la paroi de l'équipement et de la paroi de la cavité.

La pompe peut être actionnée dès que la température de contrôle (eau liquide ou paroi de l'équipement) dépasse une valeur seuil Vs. Plus cette valeur Vs est faible, plus la chaleur latente de vaporisation est importante et donc plus l'énergie absorbée par le liquide contenu dans la cavité 5 est grande. Si la pompe 8 n'est pas actionnée, l'eau liquide ralentie l'augmentation de température du système, sur la seule base de sa chaleur sensible (4,18 J/g°C). Si la pompe 8 est arrêtée et en position ouverte afin que la cavité 6 soit à la pression atmosphérique, le débit d'évaporation de l'eau liquide de la cavité 5 sera fonction de sa température (de l'eau) et de l'humidité relative de l'environnement.

Le dimensionnement de la cavité 5 est calculé afin que la réserve d'eau liquide soit suffisante pour assurer toute l'absorption d'énergie dégagée pendant la durée de fonctionnement de l'équipement dont on contrôle la température. Une rapide augmentation de température signalée par le capteur de température 7 indique que toute l'eau liquide a été vaporisée et qu'il est nécessaire de rajouter de l'eau par l'orifice prévu à cet effet.

Selon une variante de réalisation, une paroi du dispositif à refroidir sert de paroi à la cavité contenant le liquide. Dans ce cas soit le système est intégré au dispositif à refroidir et non plus ajouté au dispositif à refroidir, soit il est ajouté au dispositif. Dans ce dernier cas des moyens d'accrochage et d'étanchéité sont prévus en conséquence et le liquide est introduit dans la cavité une fois que le dispositif dont le but est de refroidir l'équipement est associé audit équipement.

Le système selon l'invention peut également fonctionner en continu à condition que la cavité 5 puisse être alimentée en eau grâce à l'orifice 9 relié au tuyau T prévu à cet effet, soit de manière continue, soit par intermittence dès que le niveau d'eau dans la cavité 5 devient trop bas. Le niveau de liquide peut être déterminé grâce à un capteur de niveau Cn de liquide dans la cavité 5. Ce capteur de niveau peut être mécanique, visuel ou tout autre moyen permettant la détection de niveau de liquide. Le capteur peut être relié à un dispositif non représenté sur la figure qui permet un déclenchement automatique du remplissage de liquide lorsque le niveau seuil n'est pas atteint.

La pompe 8 doit être adaptée à la puissance dissipée par l'équipement à refroidir et doit avoir une consommation électrique réduite. Il peut s'agir d'une micro-pompe piézométrique à diaphragme à très faible débit (Micro-pompe MDP2205 commercialisée par la société ThinXXS), à faible débit (micro-pompe rotative SP135 FZ ou eccentrique à diaphragme SP100EC ou à piston SP625PI commercialisées par la société Schwarzer Precision) ou tout autre moyen de pompage adapté aux valeurs de débit et dépression maximums nécessaire au bon fonctionnement de l'invention.

Afin d'uniformiser la température dans la cavité 5 et de favoriser le transfert de chaleur au niveau de la paroi de l'équipement, la première cavité 5 destinée à contenir l'eau liquide, ou un fluide composé d'eau liquide et de vapeur peut contenir soit de la cellulose, soit une mousse capillaire bonne conductrice de la chaleur, soit peut être nervurée ou munie d'ailettes, garantissant ainsi le bon fonctionnement thermique du dispositif quelque soit son inclinaison. La surface interne de la cavité 5 en contact avec l'équipement peut également être avantageusement totalement ou partiellement recouverte d'un matériau poreux hydrophile. Cette paroi doit être en matériau bon conducteur de la chaleur alors que les autres parois de la cavité 5 seront avantageusement mauvaises conductrice de la chaleur.

Il n'y a pas de contrainte spécifique sur le volume et sur la composition des parois de la cavité 6, par contre la surface de la membrane doit être aussi grande que possible afin de faciliter le passage de la vapeur d'eau de la cavité 5 vers la cavité 6. Une pompe à membrane pourrait être partie intégrante de cette cavité.

La figure 3 représente une variante de réalisation offrant notamment une plus grande surface d'échange avec un équipement 1 à refroidir. Dans cet exemple, la cavité 20 contenant le fluide composé de l'eau et de vapeur est disposée en contact avec l'équipement 1 à refroidir et qui dissipe de l'énergie par intermittence (ou non). Les valeurs de la surface S₂₀ de la cavité 20 et de la surface S₁ en contact avec l'équipement à refroidir sont, par exemple, sensiblement égales afin d'assurer une dissipation d'énergie plus homogène de l'équipement à refroidir. Cette égalité dans les valeurs n'est toutefois pas indispensable, et on peut trouver des systèmes de contrôle thermique qui auront une surface mise en contact avec l'équipement à refroidir plus faible que la surface de l'équipement elle-même. On retrouve aussi une membrane 22 poreuse à la vapeur d'eau et étanche à l'eau liquide, ladite membrane séparant la cavité en deux parties ou cavité 20, 21. La cavité 21 contenant la vapeur obtenue par la dissipation de l'énergie du dispositif à refroidir est rejetée vers l'extérieur, de la même façon que dans le cas de la figure 2. Un capteur de température 7 adapté à mesurer la température du fluide liquide-vapeur contenue dans la cavité ou réserve 21 ou la température de la paroi séparant l'équipement 1 et la cavité 20, est relié à une pompe 8 va permettre de rejeter dans l'environnement la vapeur d'eau du réservoir créant une dépression et cassant l'équilibre naturel liquide/vapeur du réservoir contenant l'eau liquide, provoquant ainsi une vaporisation d'une partie de l'eau liquide. De même que dans l'exemple de la figure 2, la cavité 20 est pourvue d'un orifice 9 permettant l'ajout de liquide et d'un capteur de niveau de liquide qui peut être visuel ou mécanique.

L'idée de la présente invention repose d'une part sur l'utilisation de la chaleur latente d'évaporation de l'eau comme puits de chaleur et d'autre part sur le contrôle de la pression de vapeur. Cette vaporisation nécessite une énergie, dans le cas de l'eau de l'ordre de 2 200J/g. Cette énergie est prise à l'eau liquide et à son réservoir ce qui a pour effet de baisser la température de l'eau créant ainsi un flux de chaleur de l'équipement vers le réservoir ou dispositif selon l'invention. Cette zone froide au niveau de l'eau liquide permet de baisser la température du boîtier de l'équipement, donc de baisser la température des composants électroniques ou d'autres éléments dissipant de la chaleur mais qui doivent être maintenus à basse température. La conception thermique de l'ensemble dispositif à refroidir et système de contrôle thermique selon l'invention doit être adaptée au cas par cas afin d'optimiser les échanges de chaleur. Par exemple, la paroi entre l'équipement 1 et la cavité contenant le liquide ou le fluide liquide-vapeur 20 pourrait être le condenseur d'un caloduc, l'évaporateur du caloduc étant lui-même en contact avec l'élément ou les éléments qui dissipent l'énergie. L'énergie dissipée par l'équipement sera absorbée par l'eau liquide après transport par le caloduc. S'agissant de changement de phase liquide/vapeur, le flux de chaleur entre le ou les éléments composant et l'eau liquide peut être très grand (supérieur à 1 W/cm²) tout en maintenant un très faible écart de température (quelques degrés) entre ces deux éléments.

Afin d'illustrer le fonctionnement du système selon l'invention, un exemple chiffré est donné ci-après.

Soit une micro-pompe excentrique à diaphragme permettant de pomper 0.6 l/mn de vapeur d'eau à 60°C dans la cavité (6) et consommant une puissance électrique de 0,3 W. Le pompage de la vapeur d'eau dans la cavité (6) entraine une évaporation de 0,08 g/mn d'eau liquide, ce qui représente une puissance absorbée de 3 W. Ainsi une cavité (5) de 16 cm³ initialement remplie d'eau liquide sera équivalente à un de puit de chaleur pouvant absorber 2,7 W pendant plus de 3 heures. Le volume global du système selon l'invention, micro-pompe comprise, est de l'ordre de 50 cm3.

Le système de refroidissement selon l'invention permet notamment d'obtenir une dynamique rapide et une grande capacité de transfert d'énergie pour un volume limité et faible une consommation électrique. De fait, il est possible de gérer de fortes puissances thermiques pour un faible encombrement, ce qui n'est pas le cas des systèmes de refroidissement connu du Demandeur. Ce système peut soit être intégré au boitier à refroidir, soit conçu comme un élément optionnel qui serait monté sur le boitier lorsque les conditions de fonctionnement le nécessite.

## Revendications

1. Système pour refroidir des boitiers ou équipements susceptibles de dégager de l'énergie **caractérisé en ce qu'**il comporte au moins les éléments suivants :
Une enceinte (3) comprenant une membrane (4) étanche à un liquide et poreuse à la vapeur dudit liquide, ladite membrane (4) séparant l'enceinte en une première cavité (5) destinée à contenir un fluide composé d'un liquide et de sa vapeur, une deuxième cavité (6) destinée contenir de la vapeur résultant de la vaporisation du liquide,
Un capteur de température (7) adapté à mesurer la température du fluide liquide-vapeur contenue dans la cavité (5) ou la température de paroi de la cavité (5),
Un dispositif (8) qui va permettre de rejeter dans l'environnement la vapeur de la cavité (6) créant une dépression dans cette cavité (6) et cassant l'équilibre naturel liquide/vapeur de la cavité (5) contenant le liquide, provoquant ainsi une vaporisation d'une partie du liquide,
Un moyen de contrôle du débit de la vapeur rejetée à l'extérieur de la cavité, ledit moyen de contrôle est régulé sur le signal délivré par le capteur de température (7).

2. Système selon la revendication 1 **caractérisé en ce que** le liquide est de l'eau, et la vapeur, de la vapeur d'eau.

3. Système selon la revendication 1 **caractérisé en ce que** la cavité destinée à contenir le fluide composé de liquide et de vapeur comprend un matériau hygroscopique ou un matériau à forte capillarité.

4. Système selon l'une des revendications 1 à 3 **caractérisé en ce que** le dispositif (8) de rejet de la vapeur à l'extérieur de la cavité est une pompe, ou une micro-pompe gaz/vapeur.

5. Système selon la revendication 1 **caractérisé en ce que** la cavité (5, 20) comprenant le fluide liquide-vapeur a une surface S₅, S₂₀ disposée au contact d'une surface S₁ d'un dispositif à refroidir, ladite surface S₅, S₂₀ en contact avec l'équipement (1) étant totalement ou partiellement recouverte d'un matériau poreux hydrophile.

6. Système selon la revendication 5 **caractérisé en ce que** la membrane (22) est disposée dans une position verticale, et **en ce que** la cavité (20) contenant le fluide est en contact avec le dispositif à refroidir.

7. Système selon la revendication 5 **caractérisé en ce que** la membrane (4) est disposée dans une position horizontale et **en ce que** les deux cavités (5) et (6) sont en contact avec une paroi d'un élément à refroidir.

8. Système selon la revendication 1 **caractérisé en ce que** la cavité (5) comprenant le liquide est pourvue d'un orifice (9) permettant l'ajout de liquide et d'un capteur Cn de niveau de liquide.

9. Système selon l'une des revendications 1 à 7 **caractérisé en ce que** la cavité contenant le fluide est pourvue de cellulose, soit une mousse capillaire bonne conductrice de la chaleur, soit peut être nervurée pourvue d'ailettes, garantissant ainsi le bon fonctionnement thermique du dispositif quelque soit son inclinaison.

10. Système selon l'une des revendications 1 à 9 **caractérisé en ce que** le dispositif (1) à refroidir est un boitier contenant des composants électroniques ou des composants électrochimiques.

## Patentansprüche

1. System zum Kühlen von Gehäusen oder Geräten, die dazu neigen, Energie abzugeben, **dadurch gekennzeichnet, dass** es wenigstens die folgenden Elemente umfasst:
- eine Zelle (3) mit einer Membran (4), die für eine Flüssigkeit undurchlässig und für den Dampf dieser Flüssigkeit porös ist, wobei die Membran (4) die Zelle in eine erste Kammer (5) zum Aufnehmen eines Fluids, das aus einer Flüssigkeit und deren Dampf besteht, und eine zweite Kammer (6) zum Aufnehmen des von der Verdampfung der Flüssigkeit resultierenden Dampfes unterteilt;
- einen Temperatursensor (7) zum Messen der Temperatur des in der Kammer (5) enthaltenen Flüssigkeit-Dampf-Fluids oder der Wandtemperatur der Kammer (5);
- eine Vorrichtung (8), die es zulässt, den Dampf in der Kammer (6) in die Umgebung auszustoßen, so dass ein Vakuum in dieser Kammer (6) entsteht und das natürliche Flüssigkeit/Dampf-Gleichgewicht der die Flüssigkeit enthaltenden Kammer (5) gestört wird, um so das Verdampfen eines Teils der Flüssigkeit zu bewirken;
- Mittel zum Regeln der Strömungsrate des aus der Kammer ausgestoßenen Dampfes, wobei das Regelmittel durch das vom Temperatursensor (7) angelegte Signal geregelt wird.

2. System nach Anspruch 1, **dadurch gekennzeichnet, dass** die Flüssigkeit Wasser ist und der Dampf Wasserdampf ist.

3. System nach Anspruch 1, **dadurch gekennzeichnet, dass** die Kammer, die zur Aufnahme des aus Flüssigkeit und Dampf bestehenden Fluids ausgelegt ist, ein hygroskopisches Material oder ein Material mit hoher Kapillarität umfasst.

4. System nach einem der Ansprüche 1 bis 3, **dadurch gekennzeichnet, dass** die Vorrichtung (8) zum Ausstoßen von Dampf aus der Kammer eine Pumpe oder eine Gas/Dampf-Mikropumpe ist.

5. System nach Anspruch 1, **dadurch gekennzeichnet, dass** die das Flüssigkeit-Dampf-Fluid enthaltende Kammer (5, 20) eine Oberfläche S₅, S₂₀ in Kontakt mit einer Oberfläche S₁ einer zu kühlenden Vorrichtung hat, wobei die Oberfläche S₅, S₂₀ in Kontakt mit dem Gerät (1) ganz oder teilweise von einem hydrophilen porösen Material bedeckt ist.

6. System nach Anspruch 5, **dadurch gekennzeichnet, dass** die Membran (22) in einer vertikalen Position angeordnet ist, und dadurch, dass die das Fluid enthaltende Kammer (20) mit der zu kühlenden Vorrichtung in Kontakt ist.

7. System nach Anspruch 5, **dadurch gekennzeichnet, dass** die Membran (4) in einer horizontalen Position angeordnet ist, und dadurch, dass die zwei Kammern (5) und (6) mit einer Wand eines zu kühlenden Elements in Kontakt sind.

8. System nach Anspruch 1, **dadurch gekennzeichnet, dass** die die Flüssigkeit enthaltende Kammer (5) mit einem die Zugabe von Flüssigkeit zulassenden Loch (9) und einem Flüssigkeitspegelsensor Cn versehen ist.

9. System nach einem der Ansprüche 1 bis 7, **dadurch gekennzeichnet, dass** die das Fluid enthaltende Kammer mit Cellulose versehen ist, entweder ein kapillarer Schaumstoff mit guter Wärmeleitfähigkeit, oder mit Flügel aufweisenden Rippen versehen sein kann, so dass ein guter thermischer Betrieb der Vorrichtung unabhängig von ihrer Neigung gewährleistet wird.

10. System nach einem der Ansprüche 1 bis 9, **dadurch gekennzeichnet, dass** die zu kühlende Vorrichtung (1) ein Gehäuse ist, das elektronische Komponenten oder elektrochemische Komponenten enthält.

## Claims

1. A system for cooling housings or items of equipment that are likely to release energy, **characterised in that** it comprises at least the following elements:
- an enclosure (3) comprising a membrane (4) that is impervious to a liquid and porous to the vapour of said liquid, said membrane (4) separating said enclosure into a first cavity (5) designed to contain a fluid composed of a liquid and its vapour and a second cavity (6) designed to contain the vapour resulting from the vaporisation of said liquid;
- a temperature sensor (7) designed to measure the temperature of the liquid-vapour fluid contained in said cavity (5) or the wall temperature of said cavity (5);
- a device (8) that will allow the vapour in said cavity (6) to be released into the environment, creating a vacuum in said cavity (6) and disrupting the natural liquid/vapour balance of said cavity (5) containing said liquid, thus causing the vaporisation of part of said liquid;
- means for controlling the flow rate of the vapour released outside of the cavity, with said control means being regulated on the signal delivered by said temperature sensor (7).

2. The system according to claim 1, **characterised in that** said liquid is water and said vapour is water vapour.

3. The system according to claim 1, **characterised in that** the cavity that is designed to contain the fluid composed of liquid and of vapour comprises a hygroscopic material or a material with high capillarity.

4. The system according to any one of claims 1 to 3, **characterised in that** said device (8) for discharging vapour outside of the cavity is a pump or a gas/vapour micro-pump.

5. The system according to claim 1, **characterised in that** the cavity (5, 20) comprising the liquid-vapour fluid has a surface S₅, S₂₀ arranged in contact with a surface S₁ of a device to be cooled, with said surface S₅, S₂₀ in contact with the equipment (1) being fully or partially covered by a hydrophilic porous material.

6. The system according to claim 5, **characterised in that** said membrane (22) is disposed in a vertical position, and **in that** said cavity (20) containing said fluid is in contact with said device to be cooled.

7. The system according to claim 5, **characterised in that** said membrane (4) is disposed in a horizontal position, and **in that** said two cavities (5) and (6) are in contact with a wall of an element to be cooled.

8. The system according to claim 1, **characterised in that** said cavity (5) comprising said liquid is provided with a hole (9) allowing the addition of liquid, and with a liquid level sensor Cn.

9. The system according to any one of claims 1 to 7, **characterised in that** the cavity containing said fluid is provided with cellulose, either capillary foam with good heat conductivity or can be provided with ribs equipped with vanes, thus ensuring the correct thermal operation of the device irrespective of its incline.

10. The system according to any one of claims 1 to 9, **characterised in that** said device (1) to be cooled is a housing containing electronic components or electro-chemical components.
